(19) Europäisches Patentamt / European Patent Office / Office européen des brevets

(11) **EP 2 458 695 A1**

(12) **EUROPEAN PATENT APPLICATION**
published in accordance with Art. 153(4) EPC

(43) Date of publication:
**30.05.2012 Bulletin 2012/22**

(51) Int Cl.:
*H01S 3/131* (2006.01)  *H01S 3/042* (2006.01)
*H01S 3/06* (2006.01)  *H01S 3/094* (2006.01)

(21) Application number: **11744664.1**

(22) Date of filing: **16.02.2011**

(86) International application number:
**PCT/JP2011/053268**

(87) International publication number:
**WO 2011/102378 (25.08.2011 Gazette 2011/34)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **22.02.2010 JP 2010035642**

(71) Applicant: **Fujikura, Ltd.
Tokyo 135-8512 (JP)**

(72) Inventor: **SAKAMOTO, Shinichi
Chiba 285-8550 (JP)**

(74) Representative: **Cabinet Plasseraud
52, rue de la Victoire
75440 Paris Cedex 09 (FR)**

(54) **FIBER LASER APPARATUS**

(57) A PA section (3) of a fiber laser device includes: an amplifying fiber (4); an LD (5) for exciting the amplifying fiber (4); an LD heat sink (6a) that absorbs heat generated by the LD (5); and an LD fan (7a), a thermistor (8), and a CPU (9) that control a heat resistance $R_{th}$ of the LD heat sink (6a). A temperature of the LD (5) is controlled to approach $T_{peak}$ by changing the heat resistance $R_{th}$ of the LD heat sink (6a), where $T_{peak}$ is a temperature at which a lasing wavelength of the LD (5) equals a wavelength at which an absorptance by the amplifying fiber (4) peaks.

FIG. 2

## Description

Technical Field

This invention relates to a fiber laser device, specifically to a fiber laser device improved in temperature dependence of its output intensity.

Background Art

Conventionally, a fiber laser device has been widely used for engraving of characters on a metal plate, fine processing of a metal, or the like. The fiber laser device includes an amplifying fiber having a core to which rare earth is added, and an excitation light source which emits excitation light. The fiber laser device outputs laser light by exciting the amplifying fiber by means of the excitation light. The fiber laser device has more advantages than a gas laser or a solid-state laser. That is, the fiber laser device is small-sized, lightweight, and highly efficient. Due to these advantages, the fiber laser device has been highly expected. Like the lasers mentioned above, the fiber laser device uses, as excitation light sources, a multitude of semiconductor lasers (LDs) that are capable of high output.

In a general LD, output characteristics such as a lasing wavelength or an output light intensity changes according to a temperature. Also, in the amplifying fiber, a coefficient of absorption of excitation light that enters the amplifying fiber changes according to a temperature. Consequently, an output intensity of the fiber laser device that includes the LD and the amplifying fiber has temperature dependence. In view of this, the following techniques (for example, Patent Literatures 1 to 3) have been proposed for the purpose of reducing the temperature dependence of the output intensity of the LD or the fiber laser device.

Patent Literature 1 describes a semiconductor laser device that includes a semiconductor laser section, a light output stabilizing circuit, and a lasing wavelength control section. The semiconductor laser device adjusts an output intensity of the semiconductor laser and a lasing wavelength of the semiconductor laser in the following manner. That is, the semiconductor laser section detects a variation in the output intensity of the semiconductor laser and a variation in the lasing wavelength of the semiconductor laser, the light output stabilizing circuit subsequently changes a bias current of the semiconductor laser, and then the lasing wavelength control section carries out temperature control. Thereby, the semiconductor laser device adjusts the output intensity of the semiconductor laser and the lasing wavelength of the semiconductor laser. In the semiconductor laser device, each semiconductor laser is provided with the semiconductor laser section, the light output stabilizing circuit, and the lasing wavelength control section, so that the output intensity of the semiconductor laser device can be almost fully stabilized.

Patent Literature 2 describes an optical fiber amplifier which includes an excitation light source that outputs excitation light, an amplifying fiber, two substrate-shaped peltiert elements that sandwich the amplifying fiber therebetween, and a temperature control element that controls a temperature of one of the peltiert elements. In the optical fiber amplifier, a temperature of the amplifying fiber can be controlled by means of the peltiert element, whereby a wavelength characteristic of a gain of the amplifying fiber can be stabilized.

Patent Literature 3 describes a fiber laser device which includes a power monitor at a front section, wherein part of an output from a fiber laser is feedback-controlled. In the fiber laser device, variations in output characteristics of the fiber laser device can be reduced.

Citation List

Patent Literature 1
Japanese Patent Application Publication, Tokukaihei, No. 07-015078 A (Publication Date: January 17,1995)
Patent Literature 2
Japanese Patent Application Publication, Tokukai, No. 2001-257402 A (Publication Date: September 21, 2001)
Patent Literature 3
Japanese Patent Application Publication, Tokukai, No. 2007-190566 A (Publication Date: August 2, 2007)

Summary of Invention

Technical Problem

However, in a case where the configuration according to Patent Literature 1 is applied to a high-output semiconductor laser device and an LD-excitation fiber laser device, a multitude of semiconductor lasers need to be mounted and accordingly a configuration for stabilizing output intensities of the respective semiconductor lasers becomes complicated. Further, peltiert elements are used for the temperature control in Patent Literature 1. The use of the peltiert elements results in an increased power consumption and accordingly a degradation in an output efficiency of the semiconductor laser device as a whole. Similarly, the optical fiber amplifier as described in Patent Literature 2 has degradation in output efficiency due to the use of the peltiert element as temperature control means.

The configuration according to Patent Literature 3 gives a concern that an output efficiency of the fiber laser device may significantly lower depending on an environment where the fiber laser device is used. One of the properties of the amplifying fiber is that an absorptance of excitation light that enters the amplifying fiber changes according to a wavelength of the excitation light. Also, a lasing wavelength of the LD, which is the excitation light source, has dependency on a temperature and a driving current. Due to this, the lasing wavelength of the LD is not necessarily a wavelength that the amplifying fiber can absorb with a high absorptance. This makes it difficult to always maintain the output efficiency to a high level.

The present invention is accomplished in view of the aforementioned problems. An object of the present invention is to provide a fiber laser device capable of efficient output with a stable output intensity irrespective of ambient temperatures.

Solution to Problem

In order to attain the object, a fiber laser device according to the present invention is a fiber laser device including: an amplifying fiber; an excitation light source for exciting the amplifying fiber; a heat sink that absorbs heat generated by the excitation light source and releases the absorbed heat to the outside; and heat resistance control means for controlling a heat resistance $R_{th}$ of the heat sink, the heat resistance control means controlling the heat resistance $R_{th}$ of the heat sink so that a temperature of the excitation light source approaches $T_{peak}$, where $T_{peak}$ is a temperature at which a lasing wavelength of the excitation light source equals a wavelength at which an absorptance by the amplifying fiber peaks.

In order to attain the object, a fiber laser device according to the present invention is a fiber laser device including: an amplifying fiber; a plurality of excitation light sources for exciting the amplifying fiber; a heat sink that absorbs heat generated by the plurality of excitation light sources and releases the absorbed heat to the outside; and heat resistance control means for controlling a heat resistance $R_{th}$ of the heat sink, the heat resistance control means controlling the heat resistance $R_{th}$ of the heat sink so that temperatures of the plurality of excitation light sources approach $T_{peak}$, where $T_{peak}$ is a temperature at which an average of lasing wavelengths of the plurality of excitation light sources equals a wavelength at which an absorptance by the amplifying fiber peaks.

The absorptance of the incident light from the excitation light source(s), which light enters and is absorbed by the amplifying fiber, changes depending on the wavelength of the incident light. As described above, $T_{peak}$ is the temperature at which (the average of) the lasing wavelength(s) of the excitation light source(s) equals the wavelength at which the absorptance by the amplifying fiber peaks. Because of this, if the temperature(s) of the excitation light source(s) shift(s) from $T_{peak}$, the amplifying fiber will have a decreased absorptance of incident light. According to the configuration above, however, the heat resistance control means controls the temperature(s) of the excitation light source(s) to approach $T_{peak}$, so that it becomes possible to prevent a decrease in absorptance that is caused by a shift in the wavelength of the excitation light source(s) from the wavelength at which the absorptance by the amplifying fiber peaks.

Further, the heat resistance control means controls the heat resistance $R_{th}$ of the heat sink, thereby adjusting the amount of heat to be absorbed from the excitation light source(s) to the heat sink, so that the temperature(s) of the light source(s) approach(es) $T_{peak}$. The use of the heat sink as means for controlling the temperature(s) of the excitation light source(s) enables a simple configuration and a reduction in power consumption as compared to the conventional techniques in which the peltiert elements are used as the temperature control means. Thus, it becomes possible to provide a fiber laser device capable of efficient output with a stable output intensity.

Advantageous Effects of Invention

As described above, the fiber laser device according to the present invention includes the amplifying fiber; the excitation light source for exciting the amplifying fiber; the heat sink that absorbs the heat generated by the excitation light source and releases the absorbed heat to the outside; and the heat resistance control means for controlling the heat resistance $R_{th}$ of the heat sink, the heat resistance control means controlling the heat resistance $R_{th}$ of the heat sink so that the temperature of the excitation light source approaches $T_{peak}$, where $T_{peak}$ is the temperature at which the lasing wavelength of the excitation light source equals the wavelength at which the absorptance by the amplifying fiber peaks. With this configuration, it becomes possible to provide a fiber laser device capable of efficient output with a stable output intensity.

Brief Description of Drawings

Fig. 1

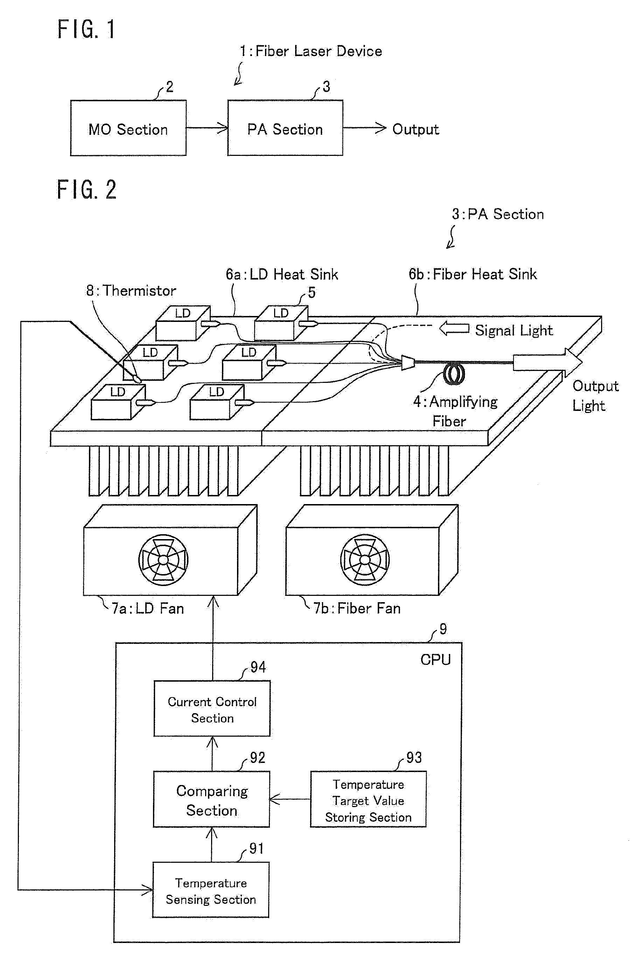

Fig. 1 is a schematic block diagram of a fiber laser device according to one embodiment of the present invention.
Fig. 2
Fig. 2 is a block diagram of a PA section of the fiber laser device.
Fig. 3

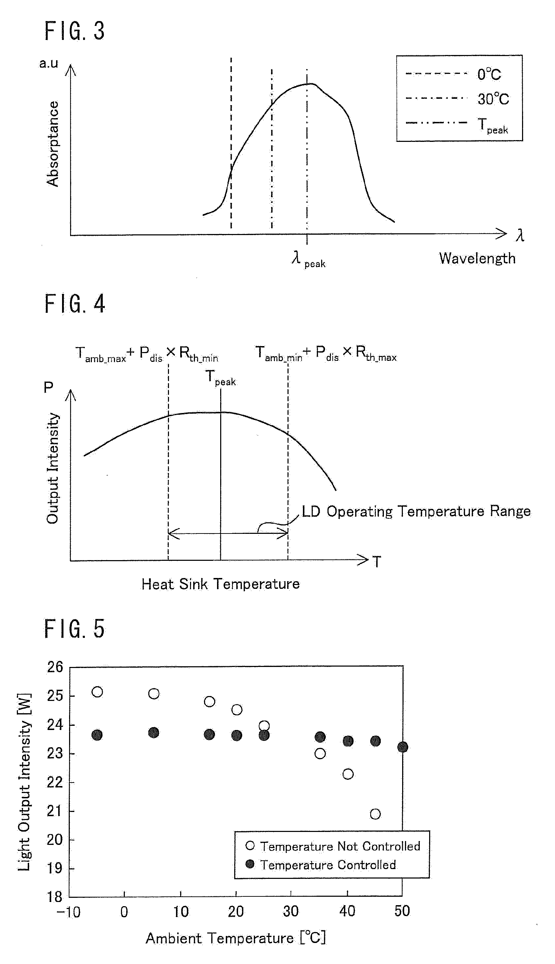

Fig. 3 is a graph showing a relation between a wavelength of incident light entering an amplifying fiber and an absorptance by the amplifying fiber.
Fig. 4
Fig. 4 is a graph showing a relation between a temperature of a heat sink and an output intensity of the fiber laser device.
Fig. 5
Fig. 5 is a graph showing a characteristic of an output intensity with respect to a temperature of an operating environment of the fiber laser device according to an example of the present invention.

Description of Embodiments

One embodiment of the present invention will be described below with reference to Figs. 1 to 4.

[Configuration of Fiber Laser Device]

Fig. 1 is a schematic block diagram of a fiber laser device 1 according to the present embodiment. The fiber laser device 1 is a fiber laser device of an MOPA (Master Oscillator Power Amplifier) type in which pulsed oscillation is carried out by use of a combination of a master oscillator and an optical amplifier. The fiber laser device 1 includes an MO section 2, which serves as an oscillating section, and a PA section 3, which serves as an amplifying section.
Fig. 2 is a block diagram of the PA section 3 as illustrated in Fig. 1. The PA section 3 includes an amplifying fiber 4, LDs (excitation light sources) 5, an LD heat sink 6a, a fiber heat sink 6b, an LD fan 7a, a fiber fan 7b, a thermistor 8, and a CPU (Central Processing Unit) 9.

Excitation light from the LDs 5 and signal light from the MO section 2 enter one end of the amplifying fiber 4. The amplifying fiber 4 has a core to which a rare-earth element such as ytterbium (Yb) or erbium (Er) is added. With this configuration, the amplifying fiber 4 amplifies the signal light from the MO section 2 and outputs the amplified signal light from the other end of the amplifying fiber 4 to an object to be processed. Although the present embodiment employs a configuration in which six LDs 5 are provided, the number of the LDs 5 according to the present invention is not limited to six.

The LD heat sink 6a is a member that absorbs heat generated by the LDs 5 and releases the absorbed heat to the outside. The LD heat sink 6a is constituted by a metal plate and radiation fins. The radiation fins are formed on one surface of the metal plate. The LDs 5 are fixed on the other surface of the metal plate. The LD fan 7a is an air-cooling fan for accelerating the heat radiation by the LD heat sink 6a. As described later, a feed rate of an air flow generated by the LD fan 7a is controlled by the thermistor 8 and the CPU 9, so that temperatures of the LDs 5 are constant at a predetermined target value.

The fiber heat sink 6b is a member that absorbs heat generated by the amplifying fiber 4 and releases the absorbed heat to the outside. The fiber heat sink 6b has a substantially identical configuration as that of the LD heat sink 6a. The air flow generated by the fiber fan 7b is supplied to the fiber heat sink 6b. The volume of the air supplied by the fiber fan 7b is constant irrespective of an ambient temperature of the fiber laser device 1.

[Control of LD Temperature]

In the present embodiment, the volume of the air supplied by the LD fan 7a to the LD heat sink 6a is adjusted according to the temperatures of the LDs 5 so as to control a heat resistance of the LD heat sink 6a. In this manner, the temperatures of the LDs 5 are controlled to a target temperature value $T_{peak}$, irrespective of the ambient temperature at which the fiber laser device 1 is used. The thermistor 8 and the CPU 9 are provided as means for performing this control. Setting of the temperature $T_{peak}$ will be described later.

The thermistor 8 is provided on the metal plate of the LD heat sink 6a and in the proximity of one of the LDs 5. The thermistor 8 outputs a voltage signal corresponding to a sensed temperature. The CPU 9 has a temperature sensing section 91, a comparing section 92, a temperature target value storing section 93, and a current control section 94. The voltage signal from the thermistor 8 is inputted to the temperature sensing section 91. The temperature sensing section 91 converts the voltage signal into a digital value and outputs the digital value to the comparing section 92. In the temperature target value storing section 93, a target value that indicates the temperature $T_{peak}$ is stored. By the comparing section 92, the digital value inputted from the temperature sensing section 91 is compared with the target value stored in the temperature target value storing section 93.

In a case where the digital value inputted from the temperature sensing section 91 is greater than the target value, that is, in a case where the temperature sensed by the thermistor 8 is above the temperature $T_{peak}$, the comparing section 92 outputs, to the current control section 94, a control signal for increasing a current to be supplied to the LD fan 7a. This increases the volume of the air supplied by the LD fan 7a to the LD heat sink 6a, whereby the heat resistance of the LD heat sink 6a decreases. As a result, an amount of heat released from the LD heat sink 6a increases, whereby the temperatures of the LDs 5 decrease down to the temperature $T_{peak}$.

In a case where the digital value inputted from the temperature sensing section 91 is smaller than the target value, that is, in a case where the temperature sensed by the thermistor 8 is below the temperature $T_{peak}$, the comparing section 92 outputs, to the current control section 94, a control signal for reducing the current to be supplied to the LD fan 7a. This reduces the volume of the air supplied by the LD fan 7a to the LD heat sink 6a, whereby the heat resistance of the LD heat sink 6a increases. As a result, the amount of heat released from the LD heat sink 6a decreases, whereby the temperatures of the LDs 5 increase up to the temperature $T_{peak}$.

In this manner, the LD fan 7a, the thermistor 8, and the CPU 9 function as heat resistance control means for controlling the heat resistance of the LD heat sink 6a so that the temperatures of the LDs 5 is $T_{peak}$.

[Setting of Temperature $T_{peak}$]

Next, the temperature $T_{peak}$ will be described below. The temperature $T_{peak}$ denotes a temperature at which the lasing wavelengths of the LDs 5 equal a wavelength $\lambda_{peak}$ at which the absorptance by the amplifying fiber 4 peaks.

Fig. 3 is a graph showing a relation between a wavelength of incident light that enters the amplifying fiber 4 and an absorptance by the amplifying fiber 4. As indicated by the solid line in Fig. 3, the absorptance by the amplifying fiber 4 peaks when the wavelength of the incident light is $\lambda_{peak}$, in an operating range of the LDs 5. Also, the lasing wavelengths of the LDs 5 change according to the temperature. In Fig. 3, the broken line, the chain line, and the two-dot chain line respectively indicate lasing wavelengths of the LDs 5 at a temperature of 0 °C, lasing wavelengths of the LDs 5 at a temperature of 30 °C, and lasing wavelengths of the LDs 5 at the temperature $T_{peak}$. Since the amplifying fiber 4 has a maximum absorptance when the wavelength of the incident light is $\lambda_{peak}$ as described above, a control that causes the LDs 5 to have the temperature $T_{peak}$ causes the absorptance of excitation light from the LDs 5 to have a maximum value.

Fig. 4 is a graph showing a relation between a temperature of the LD heat sink 6a and an output intensity P of the fiber laser device 1. This graph shows that the output intensity of the fiber laser device 1 takes a maximum value when the temperature of the LD heat sink 6a (i.e., the temperatures of the LDs 5) is $T_{peak}$. Thus, by carrying out a control so that the LDs 5 have the temperature $T_{peak}$, the output intensity of the fiber laser device 1 can be highly efficiently stabilized. Further, since the heat sink and the air-cooling fan are used as means for controlling the temperatures of the LDs 5, it is possible to reduce power consumption as compared to the conventional techniques in which the peltiert elements are used as the temperature control means.

Here, in a case where an ambient temperature specification for the fiber laser device 1 is set to a range of $T_{amb\_min}$ to $T_{amb\_max}$, it is desirable that the output intensity of the fiber laser device 1 do not vary when the fiber laser device 1 is operating under an ambient temperature in the range of $T_{amb\_min}$ to $T_{amb\_max}$. In this case, the LDs 5, the LD heat sink 6a, and the LD fan 7a to be used need to satisfy the following conditions.

First, in the present configuration in which the heat sink and the air-cooling fan are used as the temperature control means, it is impossible to control the temperatures of the LDs 5 to be below the ambient temperature. Due to this, the temperature $T_{peak}$ must be above the upper limit $T_{amb\_max}$ of the ambient temperature specification. That is, it is necessary to select the LDs 5 that satisfy the following requirement:

[Math 1]

$$T_{peak} > T_{amb\_max}$$

Next, the LD heat sink 6a and the LD fan 7a need to satisfy a requirement to be described below. The heat resistance of the LD heat sink 6a changes in accordance with the volume of air supplied from the LD fan 7a. Here, a minimum value of the heat resistance of the LD heat sink 6a, namely, the heat resistance in a case where the volume of the air supplied from the LD fan 7a peaks, is $R_{th\_min}$, and a maximum value of the heat resistance, namely, the heat resistance in a case where the LD fan 7a has been stopped, is $R_{th\_max}$. Dissipated power (i.e., amount of generated heat) from the LDs 5 is $P_{dis}$.

Then, if the fiber laser device 1 is used at the ambient temperature $T_{amb\_max}$, a lower limit down to which the temperatures of the LDs 5 can be controlled is $T_{amb\_max}+R_{th\_min}\times P_{dis}$. In a case where the temperature $T_{peak}$ is below the lower limit temperature, it is impossible to control the temperatures of the LDs 5 to $T_{peak}$ when the LDs 5 are operating at the ambient temperature $T_{amb\_max}$. Because of this, it is necessary to satisfy the following requirement:

[Math 2]

$$T_{peak} > T_{amb\_max} + R_{th\_min} \times P_{dis}$$

Likewise, if the fiber laser device 1 is used at the ambient temperature $T_{amb\_min}$, an upper limit up to which the temperatures of the LDs 5 can be controlled is $T_{amb\_min}+R_{th\_max}\times P_{dis}$. In a case where the temperature $T_{peak}$ is above the upper limit temperature, it is impossible to control the temperatures of the LDs 5 to $T_{peak}$ at the ambient temperature $T_{amb\_min}$. Because of this, it is necessary to satisfy the following requirement:

[Math 3]

$$T_{peak} < T_{amb\_min} + R_{th\_max} \times P_{dis}$$

That is, as indicated by the broken line in Fig. 4, the temperature $T_{peak}$ must be within a range of $T_{amb\_max}+R_{th\_min}\times P_{dis}$ to $T_{amb\_min}+R_{th\_max}\times P_{dis}$.

Therefore, it is necessary to use the LD heat sink 6a and the LD fan 7a that satisfy the following heat resistance requirements:

[Math 4]

$$R_{th\_min} < \frac{T_{peak} - T_{amb\_max}}{P_{dis}}$$
$$R_{th\_max} > \frac{T_{peak} - T_{amb\_min}}{P_{dis}}$$

If these requirements are satisfied, the temperatures of the LDs 5 can be always controlled to $T_{peak}$, when the LDs 5 are at the ambient temperature specification range from $T_{amb\_min}$ to $T_{amb\_max}$. Thus, the output intensity of the fiber laser device 1 can be highly efficiently stabilized.

[Control of Amplifying Fiber Temperature]

In the present embodiment, the volume of air supplied by the fiber fan 7b is constant irrespective of the ambient temperature of the fiber laser device 1. Here, the amplifying fiber 4 has such an absorption property that the lower the temperature of the amplifying fiber 4 is, the higher the absorptance of the incident light becomes. Based on this, the volume of the air from the fiber fan 7b may be variable so that the temperature of the amplifying fiber 4 is constant irrespective of the ambient temperature, in order to further stabilize the output intensity of the fiber laser device 1. In this case, the volume of the air from the fiber fan 7b is controlled in a similar manner as the volume of the air from the fan 7a is controlled. For example, the control of the volume of the air from the fiber fan 7b is carried out by feedback control in which a temperature sensed by the thermistor provided in the vicinity of the amplifying fiber 4 is fed back to the volume of the air from the fiber fan 7b so that the temperature sensed by the thermistor becomes a predetermined temperature.

Further, the absorption property of the amplifying fiber 4 varies according to the wavelength of the incident light to a greater extent than according to the temperature of the amplifying fiber 4. Therefore, the present invention may employ a configuration in which the fiber fan 7b as illustrated in Fig. 2 is not provided or a configuration in which the fiber heat sink 6b and the fiber fan 7b are not provided. These enable further simplification of the configuration of the fiber laser device 1.

[Additional Matter]

Although the above-described embodiment has a configuration in which the target value in the control of the temperatures of the LDs 5 is $T_{peak}$, the target value is not limited to $T_{peak}$ in the present invention. As an excitation light source for obtaining a high output intensity, a multi-mode LD is mainly used. The multi-mode LD outputs light with a spectrum width (3 dB bandwidth) of 3 to 6 nm. Based on this, the temperatures of the LDs 5 may be controlled so that the lasing wavelength of each of the LDs 5 is within the 3 dB bandwidth of the wavelength of the light outputted from the LD 5 with respect to the maximum absorbable wavelength $\lambda_{peak}$ of light absorbed by the amplifying fiber 4. In this case, the LD heat sink 6a and the LD fan 7a may be anything that satisfy the following relationship:

[Math 5]

$$R_{th\_min} < \frac{T - T_{amb\_max}}{P_{dis}}$$
$$R_{th\_max} > \frac{T - T_{amb\_min}}{P_{dis}}$$

where T is the target value to which the temperatures of the LDs 5 are controlled. Since the requirements on the characteristics of the LDs 5, the LD heat sink 6a, and the LD fan 7a are eased in this manner, a greater variety of LDs 5, LD heat sinks 6a, and LD fans 7a can be used.

Further, although the above-described embodiment is described on the assumption that all the LDs 5 that are used as the excitation light sources have the same temperature characteristics, the LDs 5 according to the present invention may have different temperature characteristics from one another. In this case, the temperatures of the LDs 5 is controlled so that an average of the lasing wavelengths of the LDs 5 equals the wavelength $\lambda_{peak}$, light at which wavelength can be absorbed with a peak absorptance by the amplifying fiber 4. Here, the average of the lasing wavelengths of the LDs 5 means a value obtained by dividing a sum of the lasing wavelengths of the LDs 5 by the number of LDs 5. In a case where LDs that multi-mode oscillate are used as the LDs 5, a lasing wavelength of each of the LDs 5 is defined as a center value of the 3dB bandwidth, or as a mean wavelength when an output is carried out.

Still further, although the above-described embodiment is described on the assumption that the light output intensities of the LDs 5 are constant, the present invention is not limited to this case. Instead, the temperatures of the LDs 5 may be controlled to different values depending on the respective light output intensities of the LDs 5.

The present invention is not limited to the above-described embodiments but allows various modifications within the scope of the claims. In other words, any embodiment obtained by combining technical means appropriately modified within the scope of the claims will also be included in the technical scope of the present invention.

In the fiber laser device according to the present invention, it is preferable that, in a case where the fiber laser device has a specific ambient temperature range of $T_{amb\_min}$ to $T_{amb\_max}$, the following relationship is satisfied:

[Math 1]

$$T_{peak} > T_{amb\_max}$$

According to this configuration, even if the fiber laser device is used under an environment with the temperature $T_{amb\_max}$, which is the upper limit of the ambient temperature specification of the fiber laser device, it is possible to control the temperature of the excitation light source to $T_{peak}$ by use of the heat sink and the heat resistance control means that have proper characteristics. Thus, the output intensity of the fiber laser device can be stabilized especially under a high-temperature environment.

In the fiber laser device according to the present invention, the heat resistance control means preferably includes a fan that supplies air to the heat sink, temperature sensing means for sensing the temperature of the excitation light source, and air volume control means for controlling, based on the temperature sensed by the temperature sensing means, an air volume of the air that the fan supplies.

In this configuration, the heat resistance of the heat sink can be controlled by means of an air-cooling system. This allows the temperature of the excitation light source to be controlled with a simpler configuration.

In the fiber laser device according to the present invention, it is preferable that the following relationships be satisfied:

[Math 4]

$$R_{th\_min} < \frac{T_{peak} - T_{amb\_max}}{P_{dis}}$$

$$R_{th\_max} > \frac{T_{peak} - T_{amb\_min}}{P_{dis}}$$

where $P_{dis}$ is an amount of heat generated by the excitation light source(s), $R_{th\_min}$ is a minimum value of the heat resistance, and $R_{th\_max}$ is a maximum value of the heat resistance.

This configuration allows the temperature of the excitation light source to be always $T_{peak}$ in the ambient temperature specification range of $T_{amb\_min}$ to $T_{amb\_max}$, thereby making it possible to highly efficiently stabilize the output intensity of the fiber laser device.

[Examples]

Next, the present invention will be described in further detail by use of an example. It should be noted that the present invention is not limited to this example.
In this example, the fiber laser device is exemplified as one that has a ambient temperature specification ranging from 0 °C to 50 °C, and employs, as the amplifying fiber, an Yb-added fiber whose absorptance peaks at a wavelength of 915 nm. As the excitation light sources that emit excitation light, five LDs are used. An average of lasing wavelengths of the five LDs is 905 nm under conditions of an ambient temperature of 25 °C and an output of 10 W. The lasing wavelengths of the LDs each have temperature dependency of 0.3 nm/K. Each of the LDs has light-electricity conversion efficiency of about 50%. That is, when the temperature of each of the LDs is 60 °C, the lasing wavelength of each of the LDs is 915 nm, which is the maximum absorbable wavelength for the amplifying fiber. Further, as the heat sink and the air-cooling fan that control the temperatures of the LDs, ones that each have a heat resistance of 1 K/W to 10 K/W were used.
The fiber laser device having the above-described characteristics was operated at different ambient temperatures, and output intensities of the fiber laser device at the respective ambient temperatures were measured. In the fiber laser device according to this example, the temperatures of the LDs are controlled to 60 °C even if the ambient temperature changes. Therefore, in a case where the ambient temperature is, for example, 50 °C, the volume of air from the air-cooling fan increases so that the heat resistance of the heat sink is adjusted to 2 K/W. In a case where the ambient temperature is 0 °C, the volume of air from the air-cooling fan decreases so that the heat resistance of the heat sink is adjusted to 10 K/W.
Fig. 5 is a graph showing output (light output) characteristics of fiber laser devices with respect to a temperature of an operating environment of the fiber laser devices. In Fig. 5, the filled circle sign indicates an output characteristic of the fiber laser device according to the present example, in which fiber laser device the temperatures of the LDs are controlled, whereas the unfilled circle sign indicates an output characteristic of a conventional fiber laser device, in which conventional fiber laser device the temperatures of the LDs are not controlled. This graph shows that the output intensity of the conventional fiber laser device peaks at an ambient temperature of about 0 °C and significantly decreases as the ambient temperature rises, whereas the output intensity of the fiber laser device according to the present invention is substantially constant in the ambient temperature specification range, irrespective of changes in the temperature. Thus, it was confirmed that the present invention can provide the fiber laser device capable of efficient output with a stable output intensity.

Industrial Applicability

The fiber laser device according to the present invention is applicable to laser processing, laser welding, laser marking, and the like.

Reference Signs List

1: fiber laser device
4: amplifying fiber
5: LD (excitation light source)
6a: LD heat sink (heat sink)
7a: LD fan (heat resistance control means, fan)
8: thermistor (heat resistance control means, temperature sensing means)
9: CPU (heat resistance control means, air volume control means)

**Claims**

1. A fiber laser device comprising:

an amplifying fiber;
an excitation light source for exciting the amplifying fiber;
a heat sink that absorbs heat generated by the excitation light source; and
heat resistance control means for controlling a heat resistance $R_{th}$ of the heat sink,
the heat resistance control means controlling the heat resistance $R_{th}$ of the heat sink so that a temperature of the excitation light source approaches $T_{peak}$, where $T_{peak}$ is a temperature at which a lasing wavelength of the excitation light source equals a wavelength at which an absorptance by the amplifying fiber peaks.

2. A fiber laser device comprising:

an amplifying fiber;
a plurality of excitation light sources for exciting the amplifying fiber;
a heat sink that absorbs heat generated by the plurality of excitation light sources; and
heat resistance control means for controlling a heat resistance $R_{th}$ of the heat sink,
the heat resistance control means controlling the heat resistance $R_{th}$ of the heat sink so that temperatures of the plurality of excitation light sources approach $T_{peak}$, where $T_{peak}$ is a temperature at which an average of lasing wavelengths of the plurality of excitation light sources equals a wavelength at which an absorptance by the amplifying fiber peaks.

3. The fiber laser device of claim 1 or 2, wherein:

[Math 1]

$$T_{peak} > T_{amb\_max}$$

in a case where the fiber laser device has a specific ambient temperature range of $T_{amb\_min}$ to $T_{amb\_max}$.

4. The fiber laser device of any one of claims 1, 2, and 3, wherein the heat resistance control means includes:

a fan that supplies air to the heat sink;
temperature sensing means for sensing the temperature of the excitation light source; and
air volume control means for controlling, based on the temperature sensed by the temperature sensing means, an air volume of the air that the fan supplies.

5. The fiber laser device of claim 3, wherein:

[Math 4]

$$R_{th\_min} < \frac{T_{peak} - T_{amb\_max}}{P_{dis}}$$

$$R_{th\_max} > \frac{T_{peak} - T_{amb\_min}}{P_{dis}}$$

where $P_{dis}$ is an amount of heat generated by the excitation light source(s), $R_{th\_min}$ is a minimum value of the heat resistance, and $R_{th\_max}$ is a maximum value of the heat resistance.

# FIG. 1

1 : Fiber Laser Device

```
[ MO Section ] ──→ [ PA Section ] ──→ Output
      2                  3
```

# FIG. 2

3 : PA Section

8 : Thermistor

6a : LD Heat Sink

6b : Fiber Heat Sink

5

⇐ Signal Light

LD   LD   LD   LD   LD   LD

4 : Amplifying Fiber

Output Light

7a : LD Fan

7b : Fiber Fan

9

CPU

Current Control Section — 94

Comparing Section — 92

Temperature Target Value Storing Section — 93

Temperature Sensing Section — 91

FIG. 3

FIG. 4

FIG. 5

| **INTERNATIONAL SEARCH REPORT** | International application No. |
| --- | --- |
| | PCT/JP2011/053268 |

**A.  CLASSIFICATION OF SUBJECT MATTER**
*H01S3/131*(2006.01)i, *H01S3/042*(2006.01)i, *H01S3/06*(2006.01)i, *H01S3/094*
(2006.01)i

According to International Patent Classification (IPC) or to both national classification and IPC

**B.  FIELDS SEARCHED**

Minimum documentation searched (classification system followed by classification symbols)
H01S3/131, H01S3/042, H01S3/06, H01S3/094

Documentation searched other than minimum documentation to the extent that such documents are included in the fields searched
| | | | |
| --- | --- | --- | --- |
| Jitsuyo Shinan Koho | 1922-1996 | Jitsuyo Shinan Toroku Koho | 1996-2011 |
| Kokai Jitsuyo Shinan Koho | 1971-2011 | Toroku Jitsuyo Shinan Koho | 1994-2011 |

Electronic data base consulted during the international search (name of data base and, where practicable, search terms used)

**C.  DOCUMENTS CONSIDERED TO BE RELEVANT**

| Category* | Citation of document, with indication, where appropriate, of the relevant passages | Relevant to claim No. |
| --- | --- | --- |
| Y | WO 2009/057308 A1  (Panasonic Corp.),<br>07 May 2009 (07.05.2009),<br>paragraphs [0016], [0046] to [0050]; fig. 10<br>(Family: none) | 1-5 |
| Y | WO 2009/057309 A1  (Panasonic Corp.),<br>07 May 2009 (07.05.2009),<br>paragraphs [0016], [0046] to [0050]; fig. 10<br>& US 2010/0284428 A      & CN 101842946 A | 1-5 |
| Y | JP 6-268125 A  (Fujitsu Ltd.),<br>22 September 1994 (22.09.1994),<br>paragraphs [0052] to [0053]<br>& US 5650912 A           & US 5940267 A<br>& US 6067227 A           & EP 939442 A2<br>& EP 939443 A2 | 1-5 |

| ☒  Further documents are listed in the continuation of Box C. | ☐  See patent family annex. |
| --- | --- |

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search<br>    03 March, 2011 (03.03.11) | Date of mailing of the international search report<br>    15 March, 2011 (15.03.11) |
| --- | --- |
| Name and mailing address of the ISA/<br>    Japanese Patent Office | Authorized officer |
| Facsimile No. | Telephone No. |

Form PCT/ISA/210 (second sheet) (July 2009)

**INTERNATIONAL SEARCH REPORT**

| International application No. |
|---|
| PCT/JP2011/053268 |

C (Continuation). DOCUMENTS CONSIDERED TO BE RELEVANT

| Category* | Citation of document, with indication, where appropriate, of the relevant passages | Relevant to claim No. |
|---|---|---|
| P,X | JP 2010-263026 A  (The Furukawa Electric Co., Ltd.), 18 November 2010 (18.11.2010), paragraphs [0016] to [0031]; fig. 4 (Family: none) | 1,2,4 |
| A | WO 2008/093545 A1  (Matsushita Electric Industrial Co., Ltd.), 07 August 2008 (07.08.2008), paragraphs [0082] to [0113]; fig. 12, 13 & US 2010/0103088 A | 1-5 |
| A | WO 2009/130894 A1  (Panasonic Corp.), 29 October 2009 (29.10.2009), entire text; all drawings (Family: none) | 1-5 |

Form PCT/ISA/210 (continuation of second sheet) (July 2009)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 7015078 A
- JP 2001257402 A
- JP 2007190566 A